(19) Europäisches Patentamt / European Patent Office / Office européen des brevets

(11) **EP 3 479 067 B1**

(12) **EUROPEAN PATENT SPECIFICATION**

(45) Date of publication and mention of the grant of the patent:
**13.10.2021  Bulletin 2021/41**

(21) Application number: **16734646.9**

(22) Date of filing: **01.07.2016**

(51) Int Cl.:
**G01D 3/08** (2006.01)        **G01D 5/14** (2006.01)

(86) International application number:
**PCT/EP2016/065591**

(87) International publication number:
**WO 2018/001527 (04.01.2018 Gazette 2018/01)**

(54) **ROTATIONAL POSITION SENSOR WITH TUNNEL MAGNETORESISTIVE SENSOR**

ROTATIONELLER POSITIONSSENSOR MIT TUNNEL-MAGNETORESISTIVEM SENSOR

DÉTECTEUR DE POSITION ROTATIONALLE AVEC CAPTEUR TUNNEL-MAGNETORÉSISTIF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.05.2019  Bulletin 2019/19**

(73) Proprietors:
• **thyssenkrupp Presta AG**
  **9492 Eschen (LI)**
• **thyssenkrupp AG**
  **45143 Essen (DE)**

(72) Inventors:
• **BARANYAI, Zoltán**
  **2053 Herceghalom (HU)**
• **VÉR, Ábel**
  **2083 Solymár (HU)**

(74) Representative: **thyssenkrupp Intellectual Property GmbH**
**ThyssenKrupp Allee 1**
**45143 Essen (DE)**

(56) References cited:
EP-A1- 1 382 935        EP-A1- 1 777 501
EP-A2- 2 752 645        US-A- 5 363 303
US-A1- 2016 178 403

**Description**

The present invention relates to a rotor position sensor for an electric power steering apparatus for assisting steering of a motor vehicle according to the preamble of claim 1.

An electric power steering apparatus is designed to supply a steering assist torque from an electric motor to a steering mechanism to decrease the load on the driver while steering the motor vehicle.

In recent years, in electric power steering systems brushless DC motors have come to be used. In a brushless DC motor, since a current caused to pass through a stator is PWM (Pulse Width Modulation) controlled so as to generate a rotating magnetic field according to a rotational position of a rotor, a detector is incorporated for detecting a rotor position.

In order to ensure reliability of the rotational angle detection of the motor's rotor shaft, multiple angle sensors are used. When a failure occurs in one sensor, the other sensor can still detect the position of the motor's rotor shaft to continue position measurement.

US 2016/0178403 A1 describes a fail-safe operation of an angle sensor according to the preamble of claim 1. The angle sensor has two mixed bridges with separate power supplies. A mixed bridge is an individual bridge that provides both a sine-related signal and a cosine-related signal at individual terminals of the bridge.

EP 2 752 645 A2 discloses a method for providing an abnormality detection for a rotor angle sensor. A control circuit identifies an abnormality in the sine and cosine signals in order to execute a backup control on the motor. The abnormality detection is based on a correlation between the ambient temperature of the magnetic sensor and the amplitude of the electrical signals.

EP 1 382 935 A1 describes a redundant rotation sensor having two magnetoresistive sensor elements which sense the direction of a magnetic field caused by a permanent magnet being fixed to a rotary part. The signals of the sensor elements are evaluated in two signal evaluation units which provide two angular position signals to be compared in a comparator circuit. Hereby, system failures can be detected. In case of inadmissably high differences of the sensor signals an output signal of the comparator circuit is provided indicating that the sensor apparatus does not work properly.

It is an objective of the present invention to provide an electric power steering apparatus with a rotation angle sensor having improved capability of detecting an abnormality of a magnetic sensor and in case of abnormality the sensor being able to continue measuring the rotation angle with high precision.

This problem is solved by a rotor position sensor with the features listed in claim 1 and an electric power steering apparatus with the features listed in claim 12.

Accordingly, a rotor position sensor for an electric motor of an electric power steering apparatus for assisting steering of a motor vehicle which is designed to generate a sensor signal which represents the rotor position of the electric motor's rotor is provided, wherein the rotor position sensor has at least one angle sensor unit, that generates electrical signals having different phases in accordance with rotation of a rotary shaft of the electric motor that is a sensing target, wherein the rotor position sensor comprises two redundant angle sensor units, wherein each of the sensor unit comprises tunnel magnetoresistive elements. Each angle sensor unit comprises two bridge circuits with four tunnel magnetoresistive elements. With this redundant configuration of the rotor position sensor it is always possible to calculate the correct rotor position from the electrical signals. The failure time is minimized because the rotor position sensor provides a failure tolerant system. A failure mode can be directly detected and the root cause of the error can be identified, making it possible to keep the full functionality of the sensor with the same safety level.

Preferably, for each of the magnetoresistive sensor units the four electrical signals include positive and negative sine signals having a phase difference of 180° and positive and negative cosine signals having a phase difference of 180°.

It is favoured that the rotor position sensor has a microcomputer that is designed to compute a rotation angle of the rotary shaft based on the electrical signals generated by the two magnetoresistive sensor units.

It is further favoured that the microcomputer is designed to detect an abnormality in the electrical signals. If an abnormality is detected in one of the two sensor units, it is preferred that the microcomputer is designed to calculate the rotation angle based on the electrical signals generated by the other sensor unit. The microcomputer can be designed to detect an abnormality in the electrical signals by comparison of the signals between the two redundantly working magnetoresistive sensor units and/or the microcomputer can be designed to detect the abnormality in the electrical signals by comparison of the electrical signals independently of the respective magnetoresistive sensor unit. With the usage of the sine and cosine and the inverted signal pairs in total four calculated angle signals can be compared for error detection.

Each magnetoresistive sensor unit comprises a first bridge circuit and a second bridge circuit. In a preferred embodiment the magnetoresistive sensor unit comprises a third bridge circuit and a fourth bridge circuit. With the usage of further bridge circuits more faults are tolerable while a rotation angle of the rotary shaft can still be computed.

The rotor position sensor has an offset angle between the two redundant sensor units.

Preferably, the second bridge circuit is disposed so as to be offset from the first bridge circuit by a prescribed angle of 45° or 90° in the rotation direction of the rotary shaft. Even more preferably, the first and second bridge circuits are each formed of a first half bridge circuit in which two tunnel magnetoresistive elements are connected in series, and a second half bridge circuit in which two tunnel magnetoresistive elements are connected in series, wherein the first ends of the two half bridge circuits are connected to the power source and the second ends of the two half bridge circuits are grounded.

It is advantageous, if the magnetoresistive sensor units are arranged to have an offset angle of 45° in the rotation direction of the rotary shaft.

Preferably, the two magnetoresistive sensor units including the first and second bridge circuits, respectively, are arranged in a concentric manner on the same sensor substrate.

Further an electric power steering apparatus for assisting steering of a motor vehicle by conferring torque generated by an electric motor to a steering mechanism by a rotation of a rotor of the motor in relation to a stator is provided, the apparatus comprising a rotor position sensor as described above, wherein the rotor position sensor redundantly measures the rotor position of the electric motor's rotor.

A preferred embodiment of the present invention will be described with reference to the drawings. In all figures the same reference signs denote the same components or functionally similar components.

Figure 1 shows a schematic illustration of an electric power steering apparatus;

Figure 2 is a block diagram showing an electrical structure of the electric power steering apparatus;

Figure 3 shows a schematic illustration of a sensor unit of the rotor position sensor; and

Figure 4 shows a block diagram of the rotor position sensor.

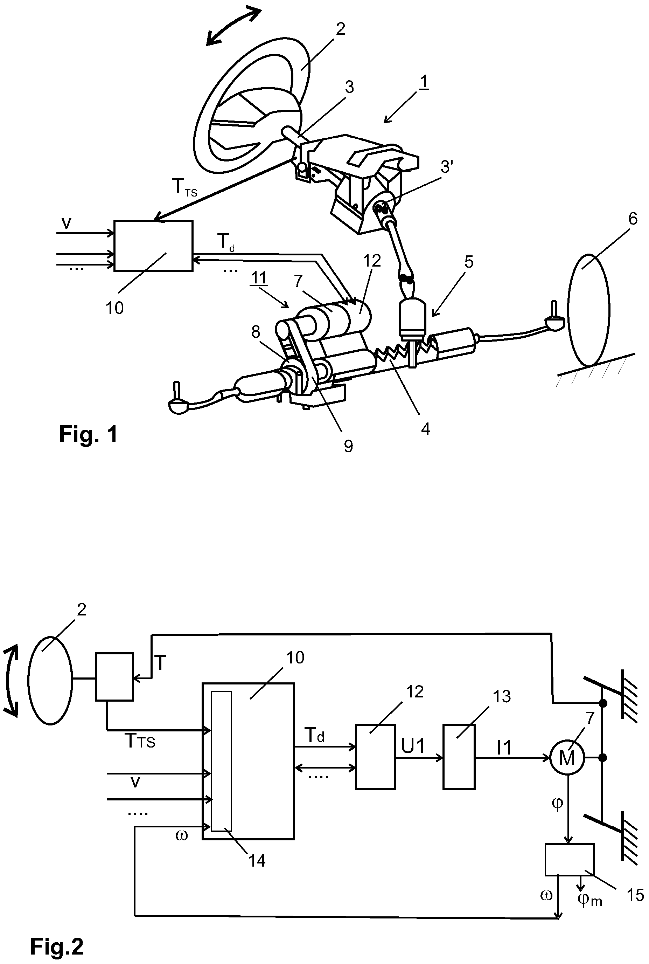

Figure 1 is a schematic diagram of an electric power steering apparatus 1. A steering wheel 2 is fixed to a upper steering shaft 3, the steering movement of the driver is transmitted via a torsion bar to a lower steering shaft 3'. The lower steering shaft 3' is coupled to a rack 4 via a rack-and-pinion mechanism 5. Rotation of the higher and lower steering shafts 3, 3' accompanying a steering operation is converted into a reciprocating linear motion of the toothed rack 4 by the rack-and-pinion mechanism 5. The linear motion of the rack 4 changes the steering angle of the steered road wheels 6. To provide steering assistance, in a preferred embodiment an electric motor 7 is mounted to the side of the rack housing and drives a ball-screw mechanism 8 via a toothed rubber belt 9. The invention is also applicable for other methods of transferring the motor torque into the steering mechanism. Electric power assist is provided through a steering controller (ECU) 10 and a power assist actuator 11 comprising the electric motor 7 and a motor controller 12. The steering controller 10 receives signals representative of the vehicle velocity v and the torque $T_{TS}$ applied to the steering wheel 2 by the vehicle operator. In response to the vehicle velocity v and the operator torque $T_{TS}$, the controller 10 determines the target motor torque $T_d$ and provides the signal through to the motor controller 12, where the duty cycles are calculated to produce the phase currents via PWM (pulse-width modulation).

Figure 2 shows a block diagram of the electrical structure of the electric power steering apparatus 1. The steering controller 10 receives signals representative of the vehicle velocity v, the torque $T_{TS}$ applied to the steering wheel 2 by the vehicle operator and the electrical angular frequency $\omega$ of the rotor of the motor 7 and derives the target motor torque $T_d$. This torque is fed to the motor controller 12 which determines the voltage input U1 for the PWM and a motor driver 13 generates via the PWM the motor currents 11= iu,iv,iw. The electric motor 7 has a rotor position sensor 15 , wherein the rotor position sensor is designed to generate a sensor signal which represents the rotation angle $\varphi$. From the rotation angle $\varphi$ the angular frequency $\omega$ is calculated in a microcomputer 14.

The rotor position sensor includes a bias magnet and a tunnel magnetoresistive element (TMR) that is a magnetic sensor. The bias magnet is fixed to an end of the motor's rotary shaft. The TMR sensor faces the bias magnet in a direction along the axis of the rotary shaft. The basic layered structures of TMR consist of two or more magnetic layers preferably of a Fe-Co-Ni alloy separated by a very thin isolating layer. One layer of the TMR is a "pinned layer" that is not affected by the magnetic field and the other is a "free layer" which has a magnetization that aligns parallel to the applied magnetic field. Electrons can surpass this thin film by means of the quantum tunnel effect, and the crossing probability is higher when both magnetic moments are aligned in parallel and lower when both magnetic moments are not aligned in parallel. So a TMR sensor usually makes use of the spin-valve principle.

The rotor position sensor 15 generates electrical signals corresponding to a rotation angle $\varphi$ of the rotary shaft. The bias magnet is a columnar bipolar magnet in which a north pole and a south pole are formed so as to be adjacent to each other in the circumferential direction. A bias magnetic field in the direction from the north pole toward the south pole is applied to the TMR sensor by the bias magnet. The direction of the magnetic field applied to the TMR sensor varies depending on the rotation angle $\varphi$ of the rotary shaft.

The rotor position sensor 15 includes a first angle sensor unit 16 and a second angle sensor unit 16' each having a first bridge circuit 17, 17' and a second bridge circuit 18, 18'. The two sensor units 16,16' work redundantly. Each is connected to the source voltage VDD and to ground GND. The tunnel magnetoresistive elements output electrical signals to the microcomputer 14. The microcomputer 14 determines whether both bridges 17, 17', 18, 18' work correct. If a failure occurs in one of the sensor units 16,16' the microcomputer 14 continues the determination of the rotor position with the output of the other sensor unit.

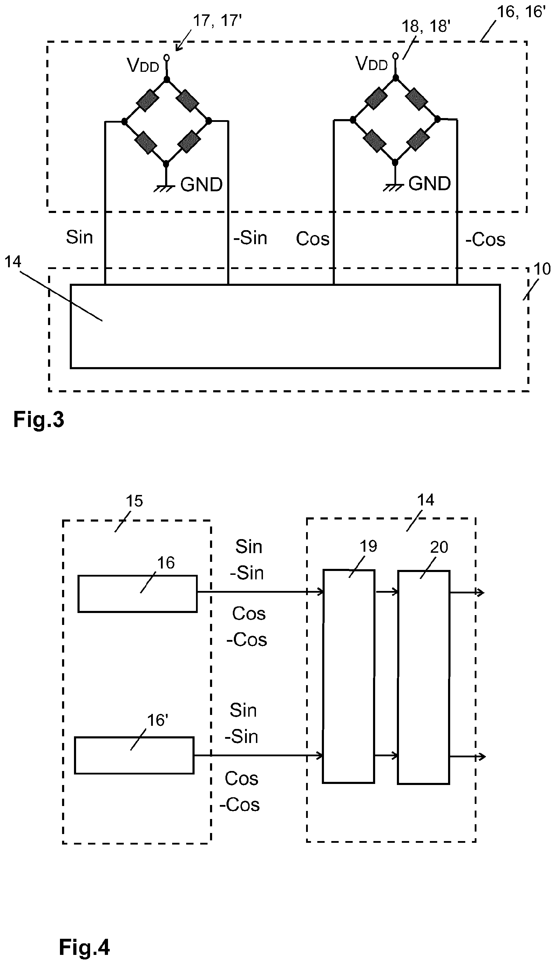

Figure 3 shows the design of a sensor unit 16,16'. The first and the second bridge circuit 17, 17', 18, 18' have a configuration in which four tunnel magnetoresistive elements are arranged in a bridge form.

The first bridge circuit 17, 17' is formed of a half bridge circuit in which two tunnel magnetoresistive elements out of the four tunnel magnetoresistive elements are connected in series, and a half bridge circuit in which the other two tunnel magnetoresistive elements are connected in series. First ends of the two half bridge circuits are connected to a power source (source voltage +VDD). Second ends of the two half bridge circuits are grounded (GND). The first bridge circuit 17, 17' outputs a potential at the middle point between the two tunnel magnetoresistive elements as a first electrical signal, and outputs a potential at the middle point between the two tunnel magnetoresistive elements as a second electrical signal.

When the bias magnet rotates together with the rotary shaft and the direction of the bias magnetic field applied to the four tunnel magnetoresistive elements varies, the resistance values of the tunnel magnetoresistive elements vary depending on the variation of the direction of the bias magnetic field. As the resistance values of the tunnel magnetoresistive elements vary, the first and second electrical signals vary. That is, the first and second electrical signals vary depending on the rotation angle $\varphi$ of the rotary shaft.

The first electrical signal is a sine signal with an amplitude A, which varies sinusoidally with respect to the rotation angle $\varphi$ of the rotary shaft. The second electrical signal is a -sine signal with an amplitude A, of which the phase is different by 180° from that of the first electrical signal.

The second bridge circuit 18, 18' has the same circuit configuration as that of the first bridge circuit 17, 17'. The second bridge circuit 18, 18' is formed of a half bridge circuit in which two tunnel magnetoresistive elements are connected in series, and a half bridge circuit in which two tunnel magnetoresistive elements are connected in series. First ends of the two half bridge circuits are connected to the power source. Second ends of the two half bridge circuits are grounded. The second bridge circuit outputs a potential at the middle point between the two tunnel magnetoresistive elements as a third electrical signal, and outputs a potential at the middle point between the two tunnel magnetoresistive elements as a fourth electrical signal.

The second bridge circuit 18, 18' is disposed so as to be offset from the first bridge circuit 17, 17' by a prescribed angle of 90° in the rotation direction of the rotary shaft. Thus, the third electrical signal is a cosine signal with an amplitude A, of which the phase is retarded by 90° with respect to that of the first electrical signal. The fourth electrical signal is a -cosine signal with an amplitude A, of which the phase is different by 180° from that of the third electrical signal.

As shown in figure 4 the microcomputer 14 acquires the electrical signals output from the first and second sensor unit 16, 16' with a prescribed sampling period. The microcomputer 14 computes in a first step 19 a sine and cosine signal for each sensor unit 16, 16'. From the four signals it is possible to detect an abnormal signal. If an abnormal signal is detected the faulty sensor unit signals are discarded and the remaining sensor unit is used to calculate the rotation angle in a second step 20.

The angle sensor unit generate different signals which correspond to sine and cosine output signals of the sensor.

Y corresponds to the Y-axis of the unit circle and X corresponds to the X-axis of the unit circle. The rotor angle calculation takes into account the offset $O_x$ $O_y$ of the signals in X and Y direction and the errors of the phase $\beta$ and the amplitude.

The rotor angle is calculated as follows

$$\varphi = \arctan(\frac{Y3}{X2}) - \beta_x$$

Wherein Y3 describes the influence of the non-orthogonality of the signals which can be compensated by using

$$Y3 = \frac{Y2 - X2 * \sin(-\beta)}{\cos(-\beta)},$$

wherein the amplitude correction X2 and Y2 is calculated by using the mean values determined in the calibration and are determined as follows

$$X2 = \frac{X1}{Axm}$$

and

$$Y2 = \frac{Y1}{Aym}$$

wherein the offset correction X1, and Y1 is calculated as follows

$$X1 = X - O_X$$

$$Y1 = Y - O_Y,$$

wherein $O_x$ describe the offset of the signals in X-direction , and $O_y$ the offset of the signals in Y-direction. Further, X and Y are given by:

$$X = Axm * \cos(\alpha + \beta_X) + O_X$$

$$Y = Aym * \sin(\alpha + \beta_Y) + O_Y$$

$$\alpha = \arctan\left(\frac{Y}{X}\right),$$

wherein $\alpha$ is the ideal rotation angle in °, so in other words it is the erroneous angle failure, wherein Axm is the mean parameter of the amplitude of X, Aym is the mean parameter of the amplitude of Y, $\beta_X$ is the phase of X signal, $\beta_Y$ is the phase of Y signal.

It is beneficial for the TMR sensor 15 to have some offset angle between the two redundant sensor units 16, 16', preferably 45°. In a preferred embodiment of the present invention each bridge leg is handled independently, providing even better fault tolerances with eight signals from two units.

The present invention provides direct diagnostics based on the bridge resistor abnormality with a simple rotor angle calculation.

**Claims**

1. A failure tolerant rotor position sensor (15) for an electric motor (7) of an electric power steering apparatus (1) for assisting steering of a motor vehicle which is designed to generate a sensor signal which represents the rotor position of the electric motor's rotor, wherein the rotor position sensor (15) has at least a first angle sensor unit (16), that generates electrical signals having different phases in accordance with rotation of a rotary shaft of the electric motor (7) that is a sensing target, and a second redundant angle sensor unit (16'), wherein each sensor unit (16, 16') has a first bridge circuit (17, 17') and a second bridge circuit (18, 18') that each have a configuration in which four tunnel magnetoresistive elements are arranged in bridge form, **characterized in that** the rotor position sensor (15) has an offset angle between the two redundant sensor units (16, 16').

2. Rotor position sensor according to claim 1, **characterized in that** for each of the angle sensor units (16, 16') the electrical signals include positive and negative sine signals having a phase difference of 180° and positive and negative cosine signals having a phase difference of 180°.

3. Rotor position sensor according to claim 1 or claim 2, **characterized in that** the rotor position sensor (15) has a microcomputer (14) that is designed to compute a rotation angle of the rotary shaft based on the electrical signals generated by the two redundant sensor units (16, 16').

4. Rotor position sensor according to claim 3, **characterized in that** the microcomputer (14) is further designed to detect an abnormality in the electrical signals.

5. Rotor position sensor according to claim 4, **characterized in that** the microcomputer (14) is further designed to calculate the rotation angle based on the electrical signals generated by one of the two sensor redundant units (16, 16') if an abnormal signal is detected in the other sensor unit (16, 16').

6. Rotor position sensor according to claim 4 or claim 5, **characterized in that** the microcomputer (14) is designed to detect the abnormality in the electrical signals by comparison of the signals between the two redundantly working sensor units (16, 16').

7. Rotor position sensor according to claim 4 or claim 5, **characterized in that** the microcomputer (14) is designed to detect the abnormality in the electrical signals by comparison of the electrical signals independently of the respective sensor unit (16, 16').

8. Rotor position sensor according to one of the preceding claims, **characterized in that** the second bridge circuit (18, 18') is disposed so as to be offset from the first bridge circuit (17, 17') by a prescribed angle of 45° in the rotation direction of the rotary shaft.

9. Rotor position sensor according to one of the preceding claims, **characterized in that** the first and second bridge circuits (17, 17', 18, 18') are formed each of a first half bridge circuit in which two tunnel magnetoresistive elements are connected in series, and a second half bridge circuit in which two tunnel magnetoresistive elements are connected in series, wherein the first ends of the two half bridge circuits are connected to the power source and the second ends of the two half bridge circuits are grounded.

10. Rotor position sensor according to one of the preceding claims, **characterized in that** the sensor units (16, 16') are arranged to have an offset angle of 45° in the rotation direction of the rotary shaft.

11. Rotor position sensor according to one of the preceding claims, **characterized in that** the two sensor units (16, 16') including the first and second bridge circuits (17, 17', 18, 18'), respectively, are arranged in a concentric manner on the same sensor substrate.

12. An electric power steering apparatus (1) for assisting steering of a motor vehicle by conferring torque generated by an electric motor (7) to a steering mechanism by a rotation of a rotor of the motor (7) in relation to a stator, the apparatus (1) comprising a rotor position sensor (15) according to one of the preceding claims, wherein the rotor position sensor (15) is able to redundantly measure the rotor position of the electric motor's rotor.

**Patentansprüche**

1. Fehlertoleranter Rotorpositionssensor (15) für einen Elektromotor (7) einer elektrischen Servolenkungsvorrichtung (1) zum Unterstützen der Lenkung eines Kraftfahrzeugs, der dazu ausgelegt ist, ein Sensorsignal zu erzeugen, das die Rotorposition des Rotors des Elektromotors repräsentiert, wobei der Rotorpositionssensor (15) mindestens eine erste Winkelsensoreinheit (16), die elektrische Signale mit unterschiedlichen Phasen gemäß der Rotation einer Drehwelle des Elektromotors (7), die ein Erfassungsziel ist, erzeugt, und eine zweite redundante Winkelsensoreinheit (16') aufweist, wobei jede Sensoreinheit (16, 16') eine erste Brückenschaltung (17, 17') und eine zweite Brückenschaltung (18, 18') aufweist, die jeweils eine Ausbildung aufweisen, bei der vier tunnelmagnetoresistive Elemente in Brückenform angeordnet sind, **dadurch gekennzeichnet, dass** der Rotorpositionssensor (15) einen Versatzwinkel zwischen den zwei redundanten Sensoreinheiten (16, 16') aufweist.

2. Rotorpositionssensor gemäß Anspruch 1, **dadurch gekennzeichnet, dass** für jede der Winkelsensoreinheiten (16, 16') die elektrischen Signale positive und negative Sinussignale mit einer Phasendifferenz von 180° und positive und negative Cosinussignale mit einer Phasendifferenz von 180° umfassen.

3. Rotorpositionssensor gemäß Anspruch 1 oder Anspruch 2, **dadurch gekennzeichnet, dass** der Rotorpositionssensor (15) einen Mikrocomputer (14) aufweist, der dazu ausgelegt ist, basierend auf den durch die zwei redundanten Sensoreinheiten (16, 16') erzeugten elektrischen Signalen einen Drehwinkel der Drehwelle zu berechnen.

4. Rotorpositionssensor gemäß Anspruch 3, **dadurch gekennzeichnet, dass** der Mikrocomputer (14) ferner dazu ausgelegt ist, eine Abnormalität in den elektrischen Signalen zu erkennen.

5. Rotorpositionssensor gemäß Anspruch 4, **dadurch gekennzeichnet, dass** der Mikrocomputer (14) ferner dazu ausgelegt ist, den Drehwinkel basierend auf den elektrischen Signalen zu berechnen, die durch eine der zwei redundanten Sensoreinheiten (16, 16') erzeugt werden, falls ein abnormales Signal in der anderen Sensoreinheit (16, 16') erkannt wird.

6. Rotorpositionssensor gemäß Anspruch 4 oder Anspruch 5, **dadurch gekennzeichnet, dass** der Mikrocomputer (14) dazu ausgelegt ist, die Abnormalität in den elektrischen Signalen durch Vergleich der Signale zwischen den zwei redundant arbeitenden Sensoreinheiten (16, 16') zu erkennen.

7. Rotorpositionssensor gemäß Anspruch 4 oder Anspruch 5, **dadurch gekennzeichnet, dass** der Mikrocomputer (14) dazu ausgelegt ist, die Abnormalität in den elektrischen Signalen durch Vergleich der elektrischen Signale unabhängig von der jeweiligen Sensoreinheit (16, 16') zu erkennen.

8. Rotorpositionssensor gemäß einem der vorhergehenden Ansprüche, **dadurch gekennzeichnet, dass** die zweite Brückenschaltung (18, 18') gegenüber der ersten Brückenschaltung (17, 17') um einen festgelegten Winkel von 45° in Drehrichtung der Drehwelle versetzt angeordnet ist.

9. Rotorpositionssensor gemäß einem der vorhergehenden Ansprüche, **dadurch gekennzeichnet, dass** die erste und zweite Brückenschaltung (17, 17', 18, 18') jeweils aus einer ersten Halbbrückenschaltung, in der zwei tunnelmagnetoresistive Elemente in Reihe geschaltet sind, und einer zweiten Halbbrückenschaltung, in der zwei tunnelmagnetoresistive Elemente in Reihe geschaltet sind, gebildet sind, wobei die ersten Enden der zwei Halbbrückenschaltungen mit der Stromquelle verbunden sind und die zweiten Enden der zwei Halbbrückenschaltungen geerdet sind.

10. Rotorpositionssensor gemäß einem der vorhergehenden Ansprüche, **dadurch gekennzeichnet, dass** die Sensoreinheiten (16, 16') mit einem Versatzwinkel von 45° in Drehrichtung der Drehwelle angeordnet sind.

11. Rotorpositionssensor gemäß einem der vorhergehenden Ansprüche, **dadurch gekennzeichnet, dass** die zwei Sensoreinheiten (16, 16') einschließlich der ersten bzw. zweiten Brückenschaltung (17, 17', 18, 18') konzentrisch auf demselben Sensorsubstrat angeordnet sind.

12. Elektrische Servolenkungsvorrichtung (1) zum Unterstützen der Lenkung eines Kraftfahrzeugs durch Übertragen eines durch einen Elektromotor (7) erzeugten Drehmoments auf einen Lenkungsmechanismus durch eine Rotation eines Rotors des Motors (7) in Bezug auf einen Stator, wobei die Vorrichtung (1) einen Rotorpositionssensor (15) gemäß einem der vorhergehenden Ansprüche umfasst, wobei der Rotorpositionssensor (15) in der Lage ist, die Rotorposition des Rotors des Elektromotors redundant zu messen.

## Revendications

1. Capteur de position de rotor à tolérance aux pannes (15) pour un moteur électrique (7) d'un appareil de direction assistée électrique (1) pour assister la direction d'un véhicule à moteur qui est conçu pour générer un signal de capteur qui représente la position de rotor du rotor du moteur électrique, le capteur de position de rotor (15) comportant au moins une première unité capteur d'angle (16) qui génère des signaux électriques ayant des phases différentes en fonction de la rotation d'un arbre rotatif du moteur électrique (7) qui est une cible de détection, et une seconde unité capteur d'angle redondante (16'), chaque unité capteur (16, 16') comportant un premier circuit en pont (17, 17') et un second circuit en pont (18, 18') qui ont chacun une configuration où quatre éléments magnétorésistifs à effet tunnel sont agencés sous la forme d'un pont, le capteur de position de rotor étant caractérisé (15) en ce qu'il comporte un angle de décalage entre les deux unités capteurs redondantes (16, 16').

2. Capteur de position de rotor selon la revendication 1, **caractérisé en ce que**, pour chacune des unités capteurs d'angle (16, 16'), les signaux électriques incluent des signaux sinusoïdaux positifs et négatifs ayant une différence de phase de 180° et des signaux cosinusoïdaux positifs et négatifs ayant une différence de phase de 180°.

3. Capteur de position de rotor selon la revendication 1 ou 2, le capteur de position de rotor (15) étant **caractérisé en ce qu'**il possède un micro-ordinateur (14) qui est conçu pour calculer un angle de rotation de l'arbre rotatif sur la base des signaux électriques générés par les deux unités capteurs redondantes (16, 16').

4. Capteur de position de rotor selon la revendication 3, **caractérisé en ce que** le micro-ordinateur (14) est en outre conçu pour détecter une anomalie dans les signaux électriques.

5. Capteur de position de rotor selon la revendication 4, **caractérisé en ce que** le micro-ordinateur (14) est en outre conçu pour calculer l'angle de rotation sur la base des signaux électriques générés par une des deux unités capteurs redondantes (16, 16') si un signal anormal est détecté dans l'autre unité capteur (16, 16').

6. Capteur de position de rotor selon la revendication 4 ou 5, **caractérisé en ce que** le micro-ordinateur (14) est conçu pour détecter l'anomalie dans les signaux électriques en comparant les signaux entre les deux unités capteurs (16, 16') qui travaillent en redondance.

7. Capteur de position de rotor selon la revendication 4 ou 5, **caractérisé en ce que** le micro-ordinateur (14) est conçu pour détecter l'anomalie dans les signaux électriques en comparant les signaux électriques indépendamment de l'unité capteur (16, 16') respective.

8. Capteur de position de rotor selon l'une quelconque des revendications précédentes, **caractérisé en ce que** le second circuit en pont (18, 18') est disposé de manière à être décalé du premier circuit en pont (17, 17') d'un angle prescrit de 45° dans le sens de rotation de l'arbre rotatif.

9. Capteur de position de rotor selon l'une quelconque des revendications précédentes, **caractérisé en ce que** les premier et second circuits en pont (17, 17', 18, 18') sont formés chacun d'un premier circuit en demi-pont où deux éléments magnétorésistifs à effet tunnel sont connectés en série et d'un second circuit en demi-pont où deux éléments magnétorésistifs à effet tunnel sont connectés en série, les premières extrémités des deux circuits en demi-pont étant connectées à la source d'alimentation et les secondes extrémités des deux circuits en demi-pont étant mises à la terre.

10. Capteur de position de rotor selon l'une quelconque des revendications précédentes, **caractérisé en ce que** les unités capteurs (16, 16') sont agencées pour avoir un angle de décalage de 45° dans le sens de rotation de l'arbre rotatif.

11. Capteur de position de rotor selon l'une quelconque des revendications précédentes, **caractérisé en ce que** les deux unités capteurs (16, 16'), qui incluent respectivement les premier et second circuits en pont (17, 17', 18, 18'), sont agencées de manière concentrique sur le même substrat de capteur.

12. Appareil de direction assistée électrique (1) pour assister la direction d'un véhicule à moteur en conférant un couple généré par un moteur électrique (7) à un mécanisme de direction par une rotation d'un rotor du moteur (7) par rapport à un stator, l'appareil (1) comprenant un capteur de position de rotor (15) selon l'une quelconque des revendications précédentes, le capteur de position de rotor (15) étant capable de mesurer de façon redondante la position de rotor du rotor du moteur électrique.

**Fig. 1**

**Fig.2**

**Fig.3**

**Fig.4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160178403 A1
- EP 2752645 A2
- EP 1382935 A1